(19) Europäisches Patentamt
European Patent Office
Office européen des brevets

(11) EP 1 512 706 A2

(12) EUROPEAN PATENT APPLICATION

(43) Date of publication:
**09.03.2005 Bulletin 2005/10**

(21) Application number: **04020326.7**

(22) Date of filing: **26.08.2004**

(51) Int Cl.[7]: **C08G 18/09**, C08G 18/69, C08G 18/71, C08G 18/76, H01B 3/00, C09J 179/00

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **29.08.2003 JP 2003307031**

(71) Applicant: **NITTO DENKO CORPORATION**
**Osaka (JP)**

(72) Inventors:
- **Uwada, Kazuki**
  **Ibaraki-shi Osaka (JP)**
- **Hotta, Yuji**
  **Ibaraki-shi Osaka (JP)**
- **Matsumura, Akiko**
  **Ibaraki-shi Osaka (JP)**

(74) Representative: **Grünecker, Kinkeldey, Stockmair & Schwanhäusser Anwaltssozietät**
**Maximilianstrasse 58**
**80538 München (DE)**

(54) **Thermosetting resin**

(57) The present invention provides a thermosetting resin which has a tensile modulus after cure of from 0.001 to 1 GPa at 35°C and which has a resin flow rate before cure under heat and pressure at 150°C and $2.94\times10^{-1}$ MPa of from 5 to 50%.

EP 1 512 706 A2

## Description

FIELD OF THE INVENTION

The present invention relates to a thermosetting resin for use in applications such as insulating materials for electronic-part-containing substrates and adhesives for wiring circuit boards.

BACKGROUND OF THE INVENTION

As a result of the recent trend toward size and weight reduction and performance advancement in electronic appliances, there is a growing desire for the high-density mounting of electronic parts comprising semiconductor elements. The trend toward size and weight reduction, which is typical especially of the field of portable appliances and the like, is thought to proceed further in the future. It is hence desired to develop a technique for mounting electronic parts on a circuit board on both sides thereof or in three-dimensional arrangement.

Among techniques which have been proposed for satisfying the desire, there is a substrate having built-in electronic parts, which contains semiconductor elements built therein and has an interlayer dielectric formed from a thermosetting resin. However, in the case where the thermosetting resins heretofore in use as insulating materials, such as epoxy resins and imide resins, are used for forming interlayer dielectrics, it is difficult to secure satisfactory suitability for embedding electronic parts. A technique has hence been proposed in which an interlayer dielectric is made beforehand to have depressions in the areas where electronic parts are to be built, in order to diminish the damage to be caused to the electronic parts by a heat/pressure treatment during the embedding of the electronic parts, to secure flatness of the substrate containing built-in electronic parts, and to secure satisfactory suitability for embedding (see, for example, patent document 1). This technique, however, has problems, for example, that the formation of such depressions in an interlayer dielectric makes production steps complicated.

An electronic-part-containing substrate which employs a thermoplastic resin as an interlayer dielectric and contains built-in semiconductor elements has hence been proposed (see, for example, patent document 2).

On the other hand, in those electronic appliances, there is a desire for high-speed signal processing for the attainment of higher functions. The adhesive layers disposed between members constituting an electronic appliance are required to have a lower permittivity especially in a high-frequency region. For example, in the flexible wiring circuit boards for use in such electronic appliances, a base insulating layer or cover insulating layer which is made of a polyimide has generally been laminated to a conductor layer made of copper through an adhesive. This adhesive is required to have a further reduced permittivity.

A technique in which an adhesive is filled with minute air bubbles to form an adhesive layer having a reduced permittivity is described (see, for example, patent document 3). However, this technique has a drawback that the degree of filling with minute air bubbles is limited and, hence, there are limitations on permittivity reduction in adhesive layers.

Materials for adhesive use which themselves have a reduced permittivity have been developed, and an adhesive comprising a polycarbodiimide is disclosed as an example (see, for example, patent document 4).

Patent Document 1: JP 11-045955 A
Patent Document 2: JP 2003-008167 A
Patent Document 3: JP 07-038209 A
Patent Document 4: JP 08-148838 A

However, use of a thermoplastic resin as an interlayer dielectric has a problem that the interlayer dielectric has poor heat resistance although suitability for embedding electronic parts can be sufficiently secured. In addition, although the adhesive layers disposed between members constituting an electronic appliance are required to have a lower permittivity in a high-frequency region, a sufficient reduction in the permittivity thereof has not been attained so far.

SUMMARY OF THE INVENTION

Accordingly, an object of the invention is to provide a low-permittivity thermosetting resin which is suitable for use as an interlayer dielectric in the production of electronic-part-containing substrates required to attain high-density mounting of electronic parts therein, has sufficient suitability for embedding electronic parts therewith, has excellent heat resistance, and is suitable for use as an adhesive in producing wiring circuit boards required to have suitability for high-speed signal processing.

Other objects and effects of the invention will become apparent from the following description.

The above-described objects of the present invention have been achieved by providing:

(1) A thermosetting resin which has a tensile modulus after cure of from 0.001 to 1 GPa at 35°C and which has a resin flow rate before cure under heat and pressure at 150°C and $2.94\times10^{-1}$ MPa of from 5 to 50%;
(2) The resin as described in (1), above which comprises a polycarbodiimide comprising:

$n_1$ pieces of structural units represented by general formula I:

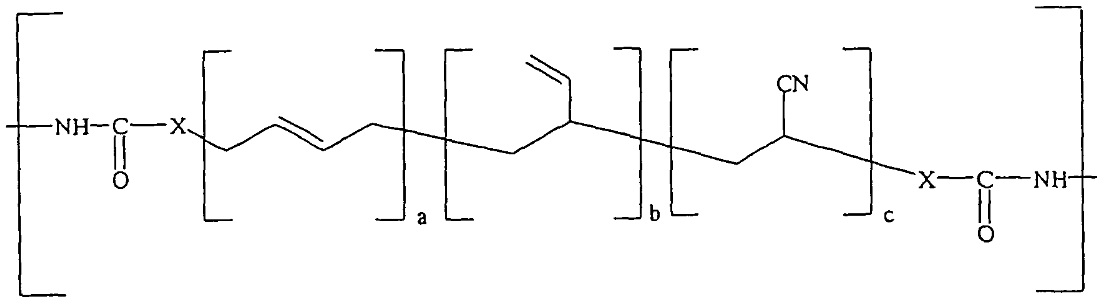
(I)

wherein a, b, and c each are an integer of 0 to 200, provided that at least one of a, b and c is not 0; and X represents a single bond or an alkylene group having 1 to 5 carbon atoms;
$n_2$ pieces of structural units represented by general formula II:

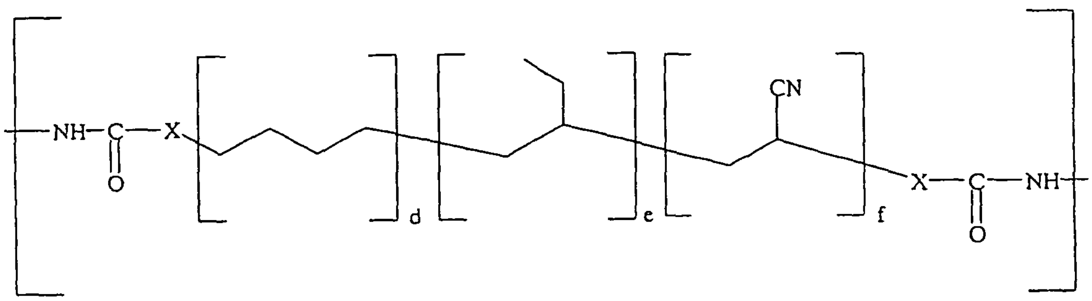
(II)

wherein d, e, and f each are an integer of 0 to 200, provided that at least one of d, e and f is not 0; and X represents a single bond or an alkylene group having 1 to 5 carbon atoms; and
$n_3$ pieces of structural units represented by general formula III:

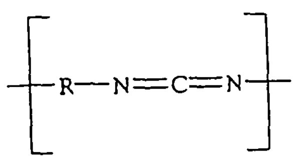
(III)

wherein R represents a bivalent organic group having 4 to 40 carbon atoms, and
having terminal structural units obtained by allowing each end of the molecules to react with a monoisocyanate,
wherein $n_1+n_2$ is an integer of 2 or larger, $n_3$ is an integer of 1 or larger, $n_1+n_2+n_3$ is from 3 to 1,500, and $(n_1+n_2) / (n_1+n_2+n_3)$ is from 1/100 to 1/3;
(3) An insulating material for electronic-part-containing substrates, which comprises the resin as described in (1) or (2) above; and
(4) An adhesive for wiring circuit boards, which comprises the resin as described in (2) above.

According to the invention, an insulating material for electronic-part-containing substrates is obtained which has sufficient suitability for embedding of electronic parts and excellent heat resistance. Furthermore, a low-permittivity adhesive for wiring circuit boards required to have suitability for high-speed signal processing is obtained.

DETAILED DESCRIPTION OF THE INVENTION

The thermosetting resin of the invention (hereinafter sometime referred to simply as "resin") after cure has a tensile modulus of from 0.001 to 1 GPa, preferably from 0.003 to 0.6 GPa, at 35°C. In the case where the resin after cure has a tensile modulus lower than 0.001 GPa, the resin gives an electronic-part-containing substrate in which the resin layer cannot retain its shape due to the internal stress caused by materials of the substrate. In the case where the resin after cure has a tensile modulus exceeding 1 GPa, the resin gives an electronic-part-containing substrate in which the internal stress caused by materials of the substrate cannot be mitigated, resulting in, for example, the warpage and swelling of the substrate.

The term "tensile modulus after cure" as used in this specification is determined through a measurement with, e.g., a dynamic viscoelastometer (DES 210, manufactured by Seiko Instruments Inc.) at 35°C after the resin is cured in a heater such as a curing oven.

The thermosetting resin of the invention has a resin flow rate under heat and pressure at 150°C and $2.94\times10^{-1}$ MPa of from 5 to 50%, preferably from 5 to 25%. In the case where the resin flow rate is lower than 5%, the stress to be imposed during embedding is concentrated on the electronic parts and, hence, the resin cannot have sufficient suitability for embedding. In the case where the resin flow rate exceeds 50%, resin outflow occurs, resulting in voids.

The term "resin flow rate" as used in this specification means an increase in area of a test piece of the resin from the initial value thereof through the holding of the test piece under application of heat and pressure over a given time period. Specifically, the area (S) of a circular test piece having a thickness of 40 μm and a diameter of 3 mm is calculated (S=7.07 $mm^2$). Subsequently, this test piece is placed on a glass plate heated at 150°C and is subjected to heat and pressure for 30 seconds while applying a pressure of $2.94\times10^{-1}$ MPa by, for example, a pair-die mounting machine (DB-100, manufactured by Shibuya Kogyo K.K.). The diameter of the test piece which has undergone the heating/pressing is measured with, e.g., a length-measuring microscope (T021, manufactured by OLYMPUS Co., Ltd.). From the found value of the diameter, the area of the test piece after the heating/pressing (S': $mm^2$) is calculated. The values obtained are introduced into the following equation:

$$\text{Resin flow rate (\%)} = \frac{S' - S}{S} \times 100$$

to calculate the resin flow rate.

As an index of the heat resistance of the thermosetting resin, glass transition point (Tg) is used in the present invention. The Tg of the resin is preferably 150°C or higher, more preferably 200°C or higher.

The resin of the invention is not particularly limited as long as it has the properties described above. However, preferred examples of the resin include a resin which comprises a polycarbodiimide comprising:

$n_1$ pieces of structural units represented by general formula I:

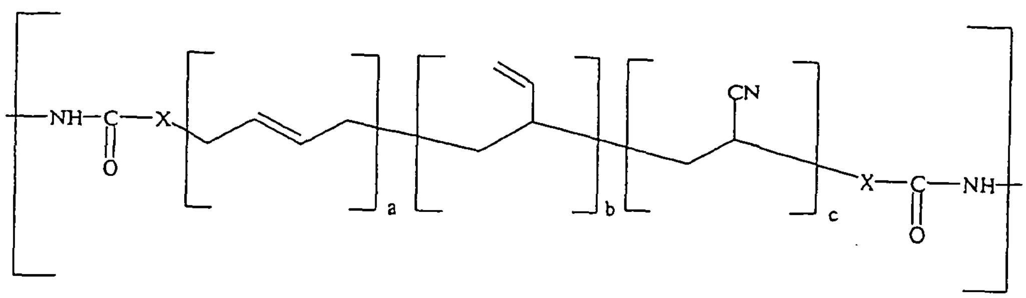

(I)

wherein a, b, and c each are an integer of 0 to 200,
provided that at least one of a, b and c is not 0; and X represents a single bond or an alkylene group having 1 to 5 carbon atoms;
$n_2$ pieces of structural units represented by general formula II:

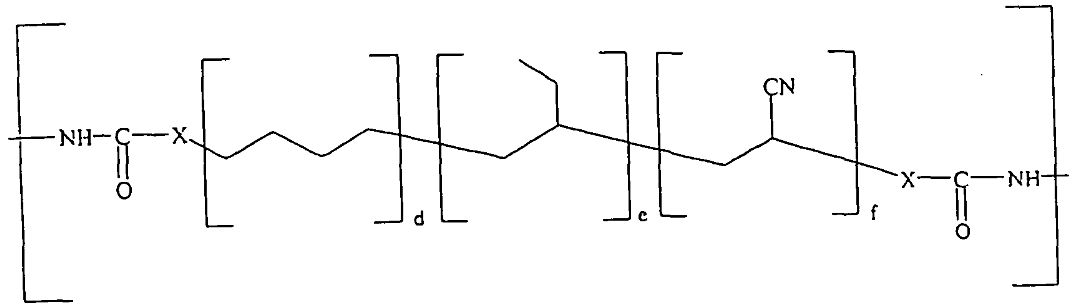

(II)

wherein d, e, and f each are an integer of 0 to 200, provided that at least one of d, e and f is not 0; and X represents a single bond or an alkylene group having 1 to 5 carbon atoms; and

$n_3$ pieces of structural units represented by general formula III:

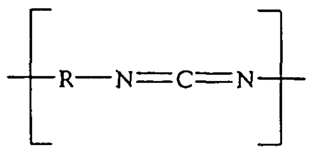

(III)

wherein R represents a bivalent organic group having 4 to 40 carbon atoms, and

having terminal structural units obtained by allowing each end of the molecules to react with a monoisocyanate,

wherein $n_1+n_2$ is an integer of 2 or larger, $n_3$ is an integer of 1 or larger, $n_1+n_2+n_3$ is from 3 to 1,500, and $(n_1+n_2)/(n_1+n_2+n_3)$ is from 1/100 to 1/3.

From the standpoint of regulating the tensile modulus after cure and the resin flow rate under heat and pressure so as to be within the ranges shown above, the values of a, b, and c each are preferably from 0 to 150, more preferably from 0 to 100. From the standpoint of regulating the tensile modulus after cure and the resin flow rate under heat and pressure so as to be within the ranges shown above, the values of d, e, and f each are preferably from 0 to 150, more preferably from 0 to 100.

X represents a single bond or an alkylene group having 1 to 5 carbon atoms. Examples of the alkylene group having 1 to 5 carbon atoms include ethylene and propylene.

R represents a bivalent organic group having 4 to 40 carbon atoms, such as, e.g., an alkylene or arylene group having 4 to 40 carbon atoms. Examples of the alkylene group having 4 to 40 carbon atoms include a hexamethylene group, a 4,4'-dicyclohexylmethane diisocyanate residue group, and an isophorone diisocyanate residue group. Examples of the arylene group having 4 to 40 carbon atoms include a tolylene group and a 4,4'-diphenylmethane diisocyanate residue group.

From the standpoint of regulating the tensile modulus after cure and the resin flow rate under heat and pressure so as to be within the ranges shown above, $n_1+n_2$ is preferably an integer of 2 to 1,000, more preferably an integer of 2 to 100, especially preferably an integer of 2 to 10; $n_3$ is preferably an integer of 1 to 500, especially preferably an integer of 1 to 300, more preferably an integer of 1 to 10; $n_1+n_2+n_3$ is preferably an integer of 3 to 20; and $(n_1+n_2)/(n_1+n_2+n_3)$ is preferably from 1/11 to 1/3.

Examples of the terminal structural unit obtained by reaction with a monoisocyanate include substituted or unsubstituted, aryl or alkyl groups. Examples of the substituted aryl groups include tolyl, isopropylphenyl, methoxyphenyl, and chlorophenyl. Examples of the unsubstituted aryl groups include phenyl and naphthyl. Examples of the substituted alkyl groups include 2,2,4-trimethylhexyl. Examples of the unsubstituted alkyl groups include alkyl groups having 1 to 10 carbon atoms, such as n-butyl, n-hexyl, and n-octyl.

In the invention, the polycarbodiimide is obtained by subjecting a bifunctional liquid rubber represented by general formula I':

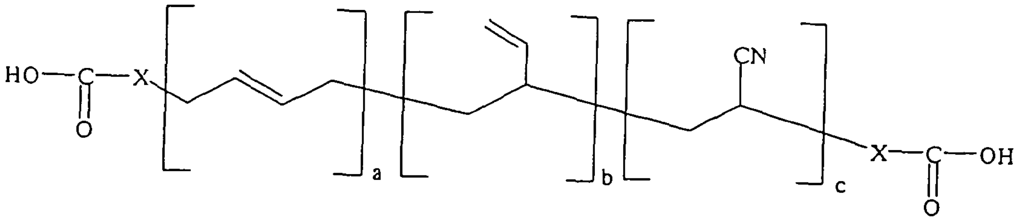 (I')

(wherein a, b, and c each are an integer of 0 to 200,
provided that at least one of a, b and c is not 0; and X represents a single bond or an alkylene group having 1 to 5 carbon atoms)
and/or a bifunctional liquid rubber represented by general formula II':

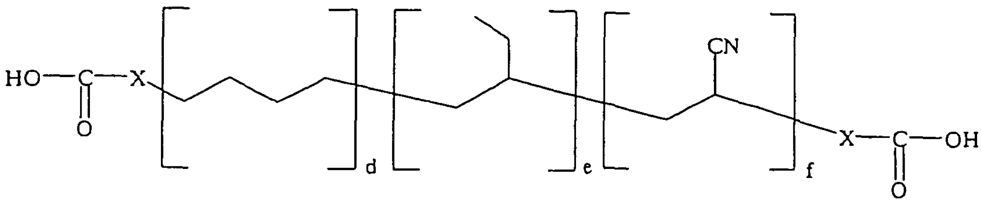 (II')

(wherein d, e, and f each are an integer of 0 to 200,
provided that at least one of d, e and f is not 0; and X represents a single bond or an alkylene group having 1 to 5 carbon atoms)
to a condensation reaction with one or more diisocyanates and then blocking each end of the condensate with a monoisocyanate. Hereinafter, the liquid rubbers represented by the above formulae may sometime be referred to simply as "bifunctional liquid rubbers".

Examples of the bifunctional liquid rubber represented by general formula I' include liquid polybutadienes (e.g., Hycar CTB (trademark), manufactured by Ube Industries, Ltd., and C-1000, manufactured by Nippon Soda Co., Ltd.) and liquid polybutadiene/acrylonitrile copolymers (e.g., Hycar CTBN (trademark), manufactured by Ube Industries, Ltd.). Examples of the bifunctional liquid rubber represented by general formula II' include liquid hydrogenated polybutadienes (e.g., CI-1000, manufactured by Nippon Soda Co., Ltd.). These bifunctional liquid rubbers may be used singly or in combination of two or more thereof.

Examples of the diisocyanates to be used as a starting material include aromatic diisocyanates and aliphatic diisocyanates. These may be used singly or in combination of two or more thereof.

Examples of the aromatic diisocyanates include compounds represented by general formula IV:

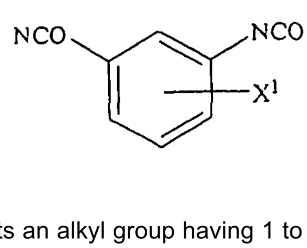 (IV)

wherein $X^1$ represents an alkyl group having 1 to 5 carbon atoms, an alkoxyl group, or a halogen atom. Specific examples thereof include 2,4-tolylene diisocyanate, 2,6-tolylene diisocyanate, 6-methoxy-2,4-phenylene diisocyanate, and 5-bromo-2,4-tolylene diisocyanate.

Examples of the aromatic diisocyanates further include compounds represented by general formula V:

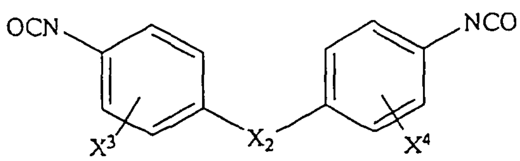

(V)

wherein $X^2$ represents a single bond, an alkylene group having 1 to 5 carbon atoms, an oxygen atom, a sulfur atom, or S(=O); and $X^3$ and $X^4$ each represent an alkyl group having 1 to 5 carbon atoms, an alkoxyl group, or a halogen atom. Specific examples thereof include 4,4'-diphenylmethane diisocyanate, 3,3',5,5'-tetraethyl-4,4'-diphenylmethane diisocyanate, 4,4'-diphenylisopropylidene diisocyanate, 4,4'-diphenyl ether diisocyanate, 4,4'-diphenyl sulfide diisocyanate, 4,4'-diphenyl sulfoxide diisocyanate, 3,3',5,5'-tetramethyl-4,4'-biphenyl diisocyanate, 3,3'-dimethoxy-4,4'-biphenyl diisocyanate, and 3,3'-dibromo-4,4'-biphenyl diisocyanate.

Examples of the aliphatic diisocyanates include compounds represented by general formula VI:

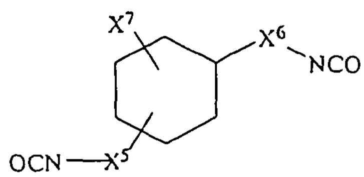

(VI)

wherein $X^5$ and $X^6$ each represent a single bond or an alkylene group having 1 to 5 carbon atoms; and $X^7$ represents an aliphatic hydrocarbon group having 1 to 8 carbon atoms. Specific examples thereof include 4,4'-dicyclohexylmethane diisocyanate, norbornane diisocyanate, 4,4'-cyclohexane diisocyanate, isophorone diisocyanate, methylcyclohexane 2,4-diisocyanate, and 2,4-bis(isocyanatomethyl)cyclohexane.

Examples of the aliphatic diisocyanates further include compounds represented by general formula VII:

$$OCN\text{-}X^8\text{-}NCO \qquad (VII)$$

wherein $X^8$ represents an alkylene group having 1 to 18 carbon atoms. Specific examples thereof include hexamethylene diisocyanate, 2,2,4-trimethylhexamethylene diisocyanate, octamethylene diisocyanate, and dodecamethylene diisocyanate.

Examples of the aliphatic diisocyanates furthermore include compounds represented by general formula VIII:

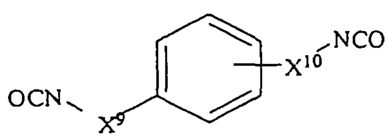

(VIII)

wherein $X^9$ and $X^{10}$ each represent a single bond or an alkylene group having 1 to 5 carbon atoms. Specific examples thereof include xylylene diisocyanate, $\alpha,\alpha,\alpha',\alpha'$-tetramethylxylylene diisocyanate, and 4-isocyanatomethylphenyl isocyanate.

The bifunctional liquid rubbers respectively represented by general formulae I' and II' are used in such molar amounts that the requirements concerning the values of $n_1$ and $n_2$ are satisfied. In the case where the rubbers of the two formulae are used in combination, the molar ratio between these, i.e., the ratio of $n_1$ to $n_2$ ($n_1/n_2$), is not particularly limited.

The molar ratio of these bifunctional liquid rubbers to the diisocyanates (bifunctional liquid rubbers/diisocyanates) is preferably from 1/99 to 1/2, more preferably from 1/10 to 1/2.

In the case where an aromatic diisocyanate and an aliphatic diisocyanate are used in combination as the diisocyanates, the molar ratio of the aromatic diisocyanate to the aliphatic diisocyanate (aromatic diisocyanate/aliphatic diisocyanate) is preferably from 3/2 to 99/1, more preferably from 4/1 to 99/1.

Examples of the monoisocyanate to be used as a starting material include isocyanates having a substituted or unsubstituted aryl group, such as phenyl isocyanate, naphthyl isocyanate, tolyl isocyanate, isopropylphenyl isocyanate, methoxyphenyl isocyanate, and chlorophenyl isocyanate; and alkyl isocyanates in which the alkyl has 1 to 10 carbon atoms, such as n-butyl isocyanate, n-hexyl isocyanate, and n-octyl isocyanate. These may be used singly or in combination of two or more thereof.

It is preferred that the monoisocyanate be used in an amount of from 1 to 40 mol per 100 mol of the diisocyanate ingredient used. Monoisocyanate ingredient amounts not smaller than 1 mol per 100 mol of the diisocyanate ingredient are preferred because the polycarbodiimide obtained neither has too high a molecular weight nor undergoes a crosslinking reaction and, for example, the polycarbodiimide solution obtained undergoes neither an increase in viscosity nor solidification nor a decrease in storage stability. Monoisocyanate ingredient amounts not larger than 40 mol per 100 mol of the diisocyanate ingredient are preferred because the polycarbodiimide solution has an appropriate viscosity and, for example, applying and drying this solution in film formation satisfactorily gives a film. The polycarbodiimide solution obtained through terminal blocking with a monoisocyanate used in an amount within that range relative to the diisocyanate ingredient has highly excellent storage stability.

By using the ingredients in the proportion described above, a polycarbodiimide in which $n_1$, $n_2$, and $n_3$ are within the respective ranges shown above can be obtained.

Specifically, the polycarbodiimide can be produced by reacting starting materials comprising the bifunctional liquid rubber and a diisocyanate in an aprotic solvent, subsequently conducting a condensation reaction to form a carbodiimide in the presence of a catalyst for carbodiimide formation, and blocking the terminals of the carbodiimide with a monoisocyanate.

The polycarbodiimide production described above is preferably conducted, for example, in the following manner. Seventy parts by weight of the bifunctional liquid rubber is mixed with 30 parts by weight of tolylene diisocyanate in toluene solvent. This mixture is stirred at 50°C for 1 hour. Thereafter, 1-naphthyl isocyanate is mixed therewith in an amount of 2 mol per 100 mol of the tolylene diisocyanate, and a catalyst for carbodiimide formation is added to the mixture. The temperature of the resultant mixture is elevated to 100°C and a carbodiimide-forming reaction is conducted at this temperature for about 2 hours to produce the target polymer. With respect to the time period of the carbodiimide-forming reaction, the end point of this reaction can be determined, for example, by the method which will be described later.

The temperature for the reaction between the bifunctional liquid rubber and the diisocyanate is preferably from 10 to 50°C, more preferably from 30 to 50°C, from the standpoints of reducing the reaction time and preventing the thermal deterioration of the liquid rubber. The reaction time may be about from 30 minutes to 2 hours, and is generally about 1 hour. The end point of the reaction is ascertained based on disappearance of the absorption attributable to the stretching vibration of OH (3,000 $cm^{-1}$) in the terminal carboxyl groups of the bifunctional liquid rubber.

The temperature for the carbodiimide-forming reaction is preferably from 10 to 150°C, more preferably from 40 to 110°C. Temperatures for the carbodiimide-forming reaction not lower than 10°C are preferred because the reaction does not necessitate too long a time and the resultant polycarbodiimide solution does not contain isocyanate functional groups remaining therein. This polycarbodiimide solution, for example, has improved storage stability. On the other hand, reaction temperatures not higher than 150°C are preferred because the reaction does not proceed too rapidly and the reaction mixture does not gel due to side reactions. The resultant polycarbodiimide solution, for example, has improved storage stability.

Examples of the catalyst for carbodiimide formation include 3-methyl-1-phenyl-2-phospholene 1-oxide, 1-phenyl-2-phospholene 1-oxide, 1-phenyl-2-phospholene 1-sulfide, 1-ethyl-3-methyl-2-phospholene 1-oxide, 3-methyl-1-phenyl-1-phospha-3-cyclopentene 1-oxide, 2,5-dihydro-3-methyl-1-phenylphosphole 1-oxide, and the 3-phospholene isomers of these phospholene compounds. Furthermore, phosphine oxides such as triphenylphosphine oxide, tritolylphosphine oxide, and bis(oxadiphenylphosphino)ethane can be used. These compounds may be used singly or in combination of two or more thereof.

The amount of the catalyst for carbodiimide formation to be used is preferably in the range of from 0.001 to 5 mol per 100 mol of all isocyanate ingredient used. Amounts thereof not less than 0.001 mol are preferred because the reaction does not necessitate too long a time. Amounts thereof not larger than 5 mol are preferred because the gelation attributable to too rapid progress of the reaction does not occur and the resultant polycarbodiimide solution, for example, has improved storage stability.

The terminal blocking with a monoisocyanate can be accomplished by adding the monoisocyanate to the reaction mixture solution in an initial, middle, or final stage in the carbodiimide formation or throughout the carbodiimide formation.

Examples of the aprotic solvent to be used in the polycarbodiimide production include toluene, xylene, alkyltoluenes in which the alkyl has 3 to 5 carbon atoms, benzene, alkylbenzenes in which the alkyl has 3 to 36 carbon atoms, naphthalene, tetrahydrofuran, dioxane, acetone, butanone, cyclohexanone, N-methylpyrrolidone, N,N-dimethylformamide, and N,N-dimethylacetamide. These may be used singly or in combination of two or more thereof.

It is preferred that the aprotic solvent be used in such an amount as to result in a polycarbodiimide solution having a polycarbodiimide concentration in the range of from 1 to 90% by weight. Polycarbodiimide concentrations not lower than 1% by weight are preferred because solvent removal in molding the polycarbodiimide obtained is easy. Polycarbodiimide concentrations not higher than 90% by weight are preferred because the polycarbodiimide solution has an appropriate viscosity and improved storage stability.

The end point of the carbodiimide-forming reaction can be ascertained based on observation of the absorption attributable to the stretching vibration of the atomic group N=C=N (2,135 $cm^{-1}$) in the polycarbodiimide yielded, disappearance of the absorption attributable to the stretching vibration of the atomic group N=C=O (2,270 $cm^{-1}$) in the isocyanate, and observation of the absorption attributable to the stretching vibration of the C=O (1,695 $cm^{-1}$) in the amide group in each linkage between the bifunctional liquid rubber and the diisocyanate.

After the completion of the carbodiimide-forming reaction, a polycarbodiimide is obtained usually as a solution. However, the solution obtained may be poured into a poor solvent such as methanol, ethanol, isopropyl alcohol, or hexane to thereby precipitate the polycarbodiimide and remove the unreacted monomers and the catalyst.

In order for preparing a solution of the polycarbodiimide which has been thus recovered as a precipitate, this precipitate is washed by a given operation, dried, and then dissolved again in an aprotic solvent. By conducting this procedure, the storage stability of the polycarbodiimide solution can be improved.

In the case where by-products are contained in the polycarbodiimide solution, this solution may be purified, for example, by using an appropriate adsorbent to adsorptively remove the by-products. Examples of the adsorbent include alumina gel, silica gel, activated carbon, zeolite, activated magnesium oxide, activated bauxite, fuller's earth, activated clay, and molecular-sieve carbon. These may be used singly or in combination of two or more thereof.

The thus-obtained resin comprising a polycarbodiimide, after cure, has a tensile modulus of from 0.001 to 1 GPa at 35°C. This resin before cure has a resin flow rate under heat and pressure at 150°C and $2.94 \times 10^{-1}$ MPa of from 5 to 50%. Compared to other thermosetting resins including epoxy resins, this resin has a higher Tg (glass transition point) and better heat resistance.

The insulating material of the invention has a feature that it comprises the thermosetting resin of the invention, e.g., a resin comprising the polycarbodiimide described above. This resin accounts for generally from 10 to 100% by weight, preferably from 30 to 100% by weight, of the insulating material.

Although uses of the insulating material are not particularly limited, the material is suitable for use as an insulating film. The film can be obtained by dissolving a resin comprising the polycarbodiimide described above in any of the aprotic solvents, e.g., toluene or cyclohexanone, applying the resultant solution to a support by a known technique such as, e.g., casting, spin coating, or roll coating, and heating and drying the solution applied. The application of the solution is preferably conducted in such an amount as to give a film having a thickness of from 10 to 200 μm.

As the support may be used any film having heat resistance and chemical resistance. Examples thereof include films of polyimides, polyesters, and poly(ethylene terephthalate). These materials may be used singly or in combination of two or more thereof. The film to be used as a support preferably is one which has been treated with a release agent such as, e.g., a fluorinated silicone.

The heating/drying of the polycarbodiimide solution applied to a support is preferably conducted under temperature/time conditions which suffice to remove the solvent, so as to dry the coating while preventing the polycarbodiimide from excessively undergoing a curing reaction. Specifically, the temperature for the heating/drying is preferably from 30 to 200°C, more preferably from 50 to 175°C, especially preferably from 70 to 150°C. Temperatures for the heating/drying not lower than 30°C are preferred because the insulating film contains no residual solvent and hence has high reliability. Temperatures therefor not higher than 200°C are preferred because the insulating film can be sufficiently dried while inhibiting the film from thermally curing. The time period of the heating/drying is preferably from 30 seconds to 30 minutes, more preferably from 1 to 10 minutes, especially preferably from 2 to 5 minutes. Time periods not shorter than 30 seconds are preferred because the insulating film contains no residual solvent and has high reliability. Time periods not longer than 30 minutes are preferred because the insulating film can be sufficiently dried while inhibiting the film from thermally curing.

In producing the insulating film, one or more of various nonconductive inorganic powders such as ceramics, e.g., alumina, silica, magnesia, and silicon nitride, may be incorporated according to need for the purpose of modulus regulation, etc.

Furthermore, the insulating film may suitably contain an inorganic filler in such an amount as not to impair the processability and heat resistance of the layer. Various additives may have been further added thereto according to need. Examples thereof include leveling agents and defoamers for imparting surface smoothness, silane coupling agents and titanate coupling agents for improving adhesion, nonionic surfactants, fluorochemical surfactants, and silicone additives. The amount of such additives to be added is preferably from 0.1 to 100 parts by weight, more preferably from 0.2 to 50 parts by weight, per 100 parts by weight of the polycarbodiimide.

When used for the embedding of electronic parts, the insulating material, e.g., insulating film, of the invention not only prevents a stress from concentrating on the electronic parts, but also is less apt to flow out and hence does

not form voids. Consequently, the insulating film can retain its layer shape regardless of the internal stress caused by materials of the electronic-part-containing substrate. Furthermore, the insulating material can sufficiently mitigated the internal stress caused by the materials of the electronic-part-containing substrate and, hence, can prevent the substrate from warping or swelling. Because of these, the insulating material of the invention is suitable for use as interlayer dielectrics in substrates having built-in electronic parts.

A process for producing a substrate having built-in electronic parts which employs the insulating material of the invention is explained below.

The substrate having built-in electronic parts is obtained, for example, by preparing a substrate having electronic parts mounted thereon, placing an insulating film as the insulating material of the invention on the side of the substrate where the electronic parts have been mounted, and press-bonding the film to the substrate with heating by means of an apparatus such as a hot press. The temperature for the heating is preferably from 50 to 250°C, more preferably from 100 to 200°C. The period of the heating is preferably from 1 second to 30 minutes, more preferably from 1 second to 1 minute. The pressure for the press bonding is preferably from $9.8\times10^{-3}$ to $2.94\times10^{-1}$ MPa.

Subsequently, the film-covered substrate is preferably further heated at about from 120 to 200°C for about from 1 to 5 hours in order to completely cure the polycarbodiimide contained in the insulating film.

The adhesive of the invention has a feature that it comprises the thermosetting resin of the invention, e.g., a resin comprising the polycarbodiimide described above. This resin accounts for generally from 10 to 100% by weight, preferably from 30 to 100% by weight, of the adhesive.

The adhesive may suitably contain an inorganic filler in such an amount as not to prevent the attainment of a reduction in permittivity. Various additives may have been further added thereto according to need. Examples thereof include leveling agents and defoamers for imparting surface smoothness, silane coupling agents and titanate coupling agents for improving adhesion, nonionic surfactants, fluorochemical surfactants, and silicone additives. The amount of such additives to be added is preferably from 0.1 to 100 parts by weight, more preferably from 0.2 to 50 parts by weight, per 100 parts by weight of the polycarbodiimide.

The adhesive of the invention has a low permittivity because it comprises the polycarbodiimide having a specific structure. The adhesive of the invention can hence be advantageously used for bonding a wiring circuit board to an insulating layer in producing a flexible wiring circuit board.

A process for producing a flexible wiring circuit board with the adhesive of the invention is explained below.

A resin comprising the polycarbodiimide described above is dissolved in any of the aprotic solvents, e.g., toluene or cyclohexanone, and this solution is applied to an insulating cover layer (e.g., a polyimide film) by a known technique such as casting, spin coating, or roll coating. The application of the solution is preferably conducted in such an amount as to result in a coating film thickness of from 10 to 50 µm. It is also possible to obtain the adhesive in the form of an adhesive film in the same manner as for the production of the insulating film described above.

A wiring circuit board obtained by forming a given copper wiring pattern on a base insulating layer (e.g., a polyimide film) is prepared. An insulating cover layer to which the adhesive has been applied or the adhesive film has been attached is placed on the pattern side of the wiring circuit board. This assemblage is treated with an apparatus such as a hot press or hot-roll laminator to thermally bond the insulating cover layer to the wiring circuit board. The temperature for the heating is generally from 50 to 250°C, preferably from 100 to 200°C. The period of the heating is preferably from 1 second to 30 minutes, more preferably from 1 second to 1 minute. By this heating, the polycarbodiimide contained in the adhesive is cured to conduct bonding. Subsequently, the resultant structure is preferably further heated at about from 120 to 200°C for about from 1 to 5 hours in order to completely cure the polycarbodiimide contained in the adhesive.

## EXAMPLES

The present invention will be illustrated in greater detail with reference to the following Examples, but the invention should not be construed as being limited thereto.

Hereinafter, all the synthesis reactions were conducted in a nitrogen stream. Analysis by IR spectroscopy was conducted with FT/IR-230 (manufactured by JEOL Ltd.).

### EXAMPLE 1

Into a 500-mL four-necked flask equipped with a stirrer, dropping funnel, reflux condenser, and thermometer were introduced 70.57 g (282 mmol) of 4,4'-diphenylmethane diisocyanate, 27.34 g (5.70 mmol) of Hycar CTB2000X162 (manufactured by B. F. Goodrich Co.), 54.68 g (39.06 mmol) of NISSO-PB CI-1000 (manufactured by Nippon Soda Co., Ltd.), and 217.96 g of cyclohexanone. The contents were stirred at 40°C for 1 hour.

Thereto were further added 10.91 g (67.68 mmol) of p-isopropylphenyl isocyanate and 0.54 g (2.82 mmol) of 3-methyl-1-phenyl-2-phospholene 2-oxide. The resultant mixture was heated to 100°C with stirring and held for further

2 hours.

The progress of reaction was ascertained by IR spectroscopy. Specifically, a decrease in the absorption attributable to the stretching vibration of the atomic group N=C=O (2,270 $cm^{-1}$) in the isocyanates and an increase in the absorption attributable to the stretching vibration of the atomic group N=C=N (2,135 $cm^{-1}$) in the polycarbodiimide were observed. Furthermore, the absorption attributable to the stretching vibration of the C=O (1,695 $cm^{-1}$) in the amide group in each linkage between the bifunctional liquid rubber and the diisocyanate was observed. After the end point of the reaction was ascertained by IR spectroscopy, the reaction mixture was cooled to room temperature to thereby obtain a polycarbodiimide solution.

In the polycarbodiimide obtained, $n_1+n_2$ was from 3 to 5, $n_3$ was from 71 to 91, $n_1+n_2+n_3$ was from 74 to 96, and $(n_1+n_2)/(n_1+n_2+n_3)$ was from 5/74 to 3/96.

EXAMPLE 2

Into a 500-mL four-necked flask equipped with a stirrer, dropping funnel, reflux condenser, and thermometer were introduced 53.30 g (213 mmol) of 4,4'-diphenylmethane diisocyanate, 32.01 g (6.67 mmol) of Hycar CTB2000X162 (manufactured by B. F. Goodrich Co.), 64.02 g (45.73 mmol) of NISSO-PB CI-1000 (manufactured by Nippon Soda Co., Ltd.), and 287.71 g of cyclohexanone. The contents were stirred at 40°C for 1 hour.

Thereto were then added 10.30 g (63.9 mmol) of p-isopropylphenyl isocyanate and 0.41 g (2.13 mmol) of 3-methyl-1-phenyl-2-phospholene 2-oxide. The resultant mixture was heated to 100°C with stirring and held for further 2 hours.

After the end point of the reaction was ascertained by IR spectroscopy in the same manner as in Example 1, the reaction mixture was cooled to room temperature to thereby obtain a polycarbodiimide solution.

In the polycarbodiimide obtained, $n_1+n_2$ was from 6 to 8, $n_3$ was from 76 to 97, $n_1+n_2+n_3$ was from 82 to 105, and $(n_1+n_2) / (n_1+n_2+n_3)$ was from 8/82 to 6/105.

EXAMPLE 3

Into a 500-mL four-necked flask equipped with a stirrer, dropping funnel, reflux condenser, and thermometer were introduced 62.81 g (251 mmol) of 4,4'-diphenylmethane diisocyanate, 28.29 g (5.89 mmol) of Hycar CTB2000X162 (manufactured by B. F. Goodrich Co.), 84.87 g (60.62 mmol) of NISSO-PB CI-1000 (manufactured by Nippon Soda Co., Ltd.), and 279.28 g of cyclohexanone. The contents were stirred at 40°C for 1 hour.

Thereto were then added 12.14 g (75.3 mmol) of p-isopropylphenyl isocyanate and 0.48 g (2.51 mmol) of 3-methyl-1-phenyl-2-phospholene 2-oxide. The resultant mixture was heated to 100°C with stirring and held for further 2 hours.

After the end point of the reaction was ascertained by IR spectroscopy in the same manner as in Example 1, the reaction mixture was cooled to room temperature to thereby obtain a polycarbodiimide solution.

In the polycarbodiimide obtained, $n_1+n_2$ was from 3 to 5, $n_3$ was from 40 to 58, $n_1+n_2+n_3$ was from 43 to 63, and $(n_1+n_2)/(n_1+n_2+n_3)$ was from 5/43 to 3/63.

EXAMPLE 4

Into a 500-mL four-necked flask equipped with a stirrer, dropping funnel, reflux condenser, and thermometer were introduced 13.93 g (80 mmol) of TDI (a mixture of 80 mol% 2,4-tolylene diisocyanate and 20 mol% 2,6-tolylene diisocyanate; manufactured by Mitsui Takeda Chemicals, Inc.), 60.06 g (240 mmol) of 4,4'-diphenylmethane diisocyanate, 34.79 g (9.94 mmol) of Hycar CTBN1300X13 (manufactured by B. F. Goodrich Co.), 52.18 g (37.27 mmol) of NISSO-PB CI-1000 (manufactured by Nippon Soda Co., Ltd.), and 259.74 g of toluene. The contents were stirred at 40°C for 1 hour.

Thereto were then added 12.38 g (76.8 mmol) of p-isopropylphenyl isocyanate and 0.62 g (3.2 mmol) of 3-methyl-1-phenyl-2-phospholene 2-oxide. The resultant mixture was heated to 100°C with stirring and held for further 2 hours.

After the end point of the reaction was ascertained by IR spectroscopy in the same manner as in Example 1, the reaction mixture was cooled to room temperature to thereby obtain a polycarbodiimide solution.

In the polycarbodiimide obtained, $n_1+n_2$ was from 5 to 7, $n_3$ was from 171 to 195, $n_1+n_2+n_3$ was from 176 to 202, and $(n_1+n_2)/(n_1+n_2+n_3)$ was from 7/176 to 5/202.

COMPARATIVE EXAMPLE 1

Into a 500-mL four-necked flask equipped with a stirrer, dropping funnel, reflux condenser, and thermometer

were introduced 74.89 g (430 mmol) of TDI (a mixture of 80 mol% 2,4-tolylene diisocyanate and 20 mol% 2,6-tolylene diisocyanate; manufactured by Mitsui Takeda Chemicals, Inc.), 107.61 g (430 mmol) of 4,4'-diphenylmethane diisocyanate, 14.55 g (86 mmol) of 1-naphthyl isocyanate, 1.65 g (8.6 mmol) of 3-methyl-1-phenyl-2-phospholene 2-oxide, and 177.34 g of toluene. The resultant mixture was heated to 100°C with stirring and held for 2 hours.

After the end point of the reaction was ascertained by IR spectroscopy in the same manner as in Example 1, the reaction mixture was cooled to room temperature to thereby obtain a polycarbodiimide solution.

Subsequently, an acrylic rubber (Nipol AR71, manufactured by Nippon Zeon Co., Ltd.) was added to the solution in an amount of 40 parts by weight per 60 parts by weight of the polycarbodiimide on a solid basis. This mixture was stirred at 30°C for 30 minutes.

In the polycarbodiimide obtained, $n_1+n_2$ was 0, $n_3$ was from 129 to 153, $n_1+n_2+n_3$ was from 129 to 153, and $(n_1+n_2)/(n_1+n_2+n_3)$ was 0.

COMPARATIVE EXAMPLE 2

Into a 500-mL four-necked flask equipped with a stirrer, dropping funnel, reflux condenser, and thermometer were introduced 111.26 g (444.6 mmol) of 4,4'-diphenylmethane diisocyanate, 31.15 g (148.2 mmol) of naphthalene diisocyanate, 26.41 g (148.2 mmol) of norbornane diisocyanate, and 206.54 g of toluene. The contents were mixed together.

Thereto were further added 7.52 g (44.46 mmol) of 1-naphthyl isocyanate and 0.71 g (3.705 mmol) of 3-methyl-1-phenyl-2-phospholene 2-oxide. The resultant mixture was stirred at 25°C for 2 hours, subsequently heated to 100°C with stirring, and held for further 2 hours.

After the end point of the reaction was ascertained by IR spectroscopy in the same manner as in Example 1, the reaction mixture was cooled to room temperature to thereby obtain a polycarbodiimide solution.

In the polycarbodiimide obtained, $n_1+n_2$ was 0, $n_3$ was from 119 to 141, $n_1+n_2+n_3$ was from 119 to 141, and $(n_1+n_2)/(n_1+n_2+n_3)$ was 0.

COMPARATIVE EXAMPLE 3

A hundred parts by weight of a bisphenol A epoxy resin (a mixture of Epikote #828 and Epikote #1001, both manufactured by Yuka Shell Epoxy K.K.; epoxy equivalent, 320 g/eq), 4 parts by weight of an imidazole hardener (1M2EZ, manufactured by Shikoku Chemical Corp.), and 40 parts by weight of an NBR (PNR-IH, manufactured by Japan Synthetic Rubber Co., Ltd.) were dissolved in methyl ethyl ketone and mixed together to obtain an epoxy resin solution.

COMPARATIVE EXAMPLE 4

Into a 500-mL four-necked flask equipped with a stirrer, dropping funnel, reflux condenser, and thermometer were introduced 74.89 g (430 mmol) of TDI (a mixture of 80 mol% 2,4-tolylene diisocyanate and 20 mol% 2,6-tolylene diisocyanate; manufactured by Mitsui Takeda Chemicals, Inc.), 107.61 g (430 mmol) of 4,4'-diphenylmethane diisocyanate, 14.55 g (86 mmol) of 1-naphthyl isocyanate, 1.65 g (8.6 mmol) of 3-methyl-1-phenyl-2-phospholene 2-oxide, and 177.34 g of toluene. The resultant mixture was heated to 100°C with stirring and held for 2 hours.

After the end point of the reaction was ascertained by IR spectroscopy in the same manner as in Example 1, the reaction mixture was cooled to room temperature to thereby obtain a polycarbodiimide solution.

In the polycarbodiimide obtained, $n_1+n_2$ was 0, $n_3$ was from 129 to 153, $n_1+n_2+n_3$ was from 129 to 153, and $(n_1+n_2)/(n_1+n_2+n_3)$ was 0.

TEST EXAMPLE 1

Each of the polycarbodiimide solutions obtained in Examples 1 to 4 and Comparative Examples 1 and 2 was applied with a roll coater to a separator (thickness, 50 μm; manufactured by Mitsubishi Polyester Film Japan) made of a poly(ethylene terephthalate) film treated with a release agent (fluorinated silicone), in such an amount as to give an insulating film having a thickness of 40 μm. This coated separator was heated at 130°C for 1 minute and then at 150°C for 1 minute. Thus, insulating films 1 to 6 each covered with a separator were obtained.

The insulating films obtained were examined for glass transition point, resin flow rate before cure, and tensile modulus after cure by the following measuring methods. The measurements were made after the separator was removed. The results obtained are shown in Table 1.

Glass Transition Point

Modulus was measured with a dynamic viscoelastometer (DES 210, manufactured by Seiko Instruments Inc.) in the tensile mode under the conditions of a frequency of 50 Hz and a heating rate of 10°C/min. The glass transition point was determined from an inflection point in the modulus curve.

Resin Flow Rate Before Cure

A disk having a diameter of 3 mm was punched out of an insulating film having a thickness of 40 µm with a stainless-steel punch having a diameter of 3 mm to obtain a test piece (area S = 7.07 $mm^2$). A glass plate having dimensions of 14 cm × 14 cm was set on the stage of a pair-die mounting machine (DB-100, manufactured by Shibuya Kogyo K.K.), in which the stage had a heating mechanism. The stage was heated so as to result in a glass plate temperature of 150°C. The test piece was heated and pressed on this glass plate at a pressure of $2.94 \times 10^{-1}$ MPa for 30 seconds. After the heating/pressing, the diameter of the test piece on the glass plate was measured with a length-measuring microscope (T021, manufactured by OLYMPUS Co., Ltd.). From the found value of the diameter, the area of test piece after the heating/pressing (S') was calculated. The values obtained were introduced into the following equation:

$$\text{Resin flow rate (\%)} = \frac{S' - S}{S} \times 100$$

to calculate the resin flow rate.

Tensile Modulus After Cure

An insulating film having a thickness of 40 µm was heated at 175°C for 5 hours with a precision thermostatic chamber (Safety Fine Oven DH-62Z, manufactured by Yamato Scientific Co., Ltd.) to cure the insulating film. The insulating film thus cured was examined for tensile modulus after cure under the conditions of 35°C and a frequency of 50 Hz using a dynamic viscoelastometer (DES 210, manufactured by Seiko Instruments Inc.).

Table 1

| Insulating film | 1 | 2 | 3 | 4 | 5 | 6 |
|---|---|---|---|---|---|---|
| Resin | Example 1 | Example 2 | Example 3 | Example 4 | Comparative Example 1 | Comparative Example 2 |
| Glass transition point (°C) | 208 | 223 | 168 | 216 | 92 | 205 |
| Resin flow rate (%) | 11.19 | 14.63 | 20.33 | 5.82 | 61.20 | 1.43 |
| Tensile modulus after cure (GPa) | 0.018 | 0.005 | 0.003 | 0.560 | - | 2.280 |

The results given in Table 1 show the following. The insulating film of Comparative Example 1 had a glass transition point as low as below 100°C. Insulating film 5, which had been produced from the polycarbodiimide solution of Comparative Example 1, had a far higher resin flow rate than insulating films 1 to 4, which had been produced from the polycarbodiimide solutions of Examples 1 to 4. Insulating film 5 was highly apt to flow in the heating/pressing. At 35°C, insulating film 5 completely stretched out without retaining its shape, so that the tensile modulus after cure thereof could not be measured. Insulating film 6, which had been produced from the polycarbodiimide solution of Comparative Example 2, had a lower resin flow rate and was exceedingly less apt to undergo resin flow in the heating/pressing as compared with insulating films 1 to 4, which had been produced from the polycarbodiimide solutions of Examples 1 to 4, although it had a high glass transition point. In addition, insulating film 6 had a high tensile modulus after cure.

TEST EXAMPLE 2

A silicon chip having a thickness of 150 µm was mounted on a circuit board produced by forming a circuit pattern on a copper-clad two-layer substrate, as a starting material, comprising a polyimide and a copper foil. Each of

insulating films (thickness, 200 μm) produced in the same manners as in the Examples was placed on the circuit pattern side of this circuit board. After the separator was removed, each resultant assemblage was heated and pressed with a vacuum pressing machine (VH1-572, manufactured by Kitagawa Seiki Co., Ltd.) at 150°C and $2.94 \times 10^{-1}$ MPa for 30 seconds under a vacuum of 2,660 Pa to conduct embedding of a silicon chip in the insulating film. Subsequently, the substrate which had undergone the heating/pressing was heated at 175°C for 5 hours to cure the insulating layer consisting of the insulating film. Thus, electronic-part-containing substrates 1 to 6 were obtained.

The electronic-part-containing substrates obtained were evaluated for suitability for chip embedding, voids, and substrate warpage by the following evaluation methods. The results obtained are shown in Table 2.

Suitability for Chip Embedding

The electronic-part-containing substrate was polished with a polisher (Labopol-5, manufactured by Marumoto Struers K.K.) so that a section which transversed the silicon chip was obtained. Subsequently, the section formed by polishing was examined for the presence of a gap at the periphery of the silicon chip.

Evaluation Criteria:

A: No gap was present
B: Gap was present

Void

The section was examined for the presence of voids in the insulating layer.

Evaluation Criteria:

A: No voids were present
B: Voids were present

Substrate Warpage

The electronic-part-containing substrate was placed on a flat plane, and the degree of warpage at the most warped part was measured with a scale. The warpage was evaluated according to the following evaluation criteria.

Evaluation Criteria:

A: Amount of warpage was less than 1 mm
B: Amount of warpage was 1 mm or larger

Table 2

| Electronic-part-containing substrate | 1 | 2 | 3 | 4 | 5 | 6 |
|---|---|---|---|---|---|---|
| Insulating film | 1 | 2 | 3 | 4 | 5 | 6 |
| Suitability for chip embedding | A | A | A | A | A | B |
| Void in substrate | A | A | A | A | B | A |
| Substrate warpage | A | A | A | A | A | B |

The results given in Table 2 show the following. In each of electronic-part-containing substrates 1 to 4, which had been fabricated with the insulating films 1 to 4 produced from the polycarbodiimide solutions of Examples 1 to 4, the insulating material had conformed to the chip and filled the spaces around the chip periphery. Namely, these insulating films showed satisfactory suitability for embedding. Furthermore, neither voids nor substrate warpage was observed.

In contrast, in electronic-part-containing substrate 5, which had been fabricated with the insulating film 5 produced from the polycarbodiimide solution of Comparative Example 1, voids were observed in the insulating layer. In electronic-part-containing substrate 6, which had been fabricated with the insulating film 6 produced from the polycarbodiimide solution of Comparative Example 2, the insulating film showed poor suitability for embedding and the substrate warped considerably. In the silicon chip embedding in fabricating electronic-part-containing substrate 6, the insulating film rose considerably in its part overlying the chip. This is thought to be attributable to the poor suitability

of the insulating film 6 for chip embedding.

TEST EXAMPLE 3

Each of the polycarbodiimide solutions obtained in Examples 1 to 4 and Comparative Examples 4 was applied with a roll coater to a separator (thickness, 50 µm; manufactured by Mitsubishi Polyester Film Japan) made of a poly (ethylene terephthalate) film treated with a release agent (fluorinated silicone), in such an amount as to give an adhesive film having a thickness of 25 µm. This coated separator was heated at 130°C for 1 minute and then at 150°C for 1 minute. Thus, adhesive films 1 to 4 and 6 (thickness, 25 µm) each covered with a separator were obtained. The epoxy resin solution obtained in Comparative Example 3 was applied with a roll coater to a separator (thickness, 50 µm; manufactured by Mitsubishi Polyester Film Japan) consisting of a poly(ethylene terephthalate) film treated with a release agent (fluorinated silicone), in such an amount as to give an adhesive film having a thickness of 25 µm. This coated separator was heated at 120°C for 3 minutes to obtain adhesive film 5 (thickness, 25 µm) covered with a separator.

The separator-covered adhesive films obtained were cured by heating at 175°C for 5 hours for adhesive films 1 to 4 and 6 or by heating at 150°C for 3 hours for adhesive film 5. Thus, test samples were obtained.

The adhesive films 1 to 6 which had been thus cured were examined for permittivity and dielectric dissipation factor by the following measuring methods. The measurements were made after the separator was removed. The results obtained are shown in Table 3.

Permittivity

The permittivity of a test sample was measured at a frequency of 10 GHz with an apparatus for evaluating complex permittivity by the cavity resonator perturbation method (manufactured by Kanto Electronics Application and Development Inc.).

Dielectric Dissipation Factor

The dielectric dissipation factor of a test sample was measured at a frequency of 10 GHz with an apparatus for evaluating complex permittivity by the cavity resonator perturbation method (manufactured by Kanto Electronics Application and Development Inc.).

Table 3

| Adhesive film | 1 | 2 | 3 | 4 | 5 | 6 |
|---|---|---|---|---|---|---|
| Permittivity | 2.61 | 2.54 | 2.49 | 2.49 | 3.8 | 3.73 |
| Dielectric dissipation factor | 0.006 | 0.005 | 0.005 | 0.007 | 0.017 | 0.006 |

The results given in Table 3 show the following. A comparison between adhesive films 1 to 4, which had been produced from the polycarbodiimide solutions of Examples 1 to 4, and adhesive films 5 and 6, which had been produced from the polycarbodiimide solutions of Comparative Examples 3 and 4, shows that adhesive film 5 had a high permittivity and a high dielectric dissipation factor and adhesive film 6 had a high permittivity. It can hence be seen that these two adhesive films have an exceedingly high dielectric loss. Consequently, it is thought that when adhesive film 5 or 6 is used to fabricate a wiring circuit board, this circuit board cannot be used for the high-speed transmission of a large quantity of data at a high frequency and a high density.

The resin comprising a polycarbodiimide of the invention has satisfactory suitability for electronic part embedding and, hence, can be used for the production of electronic-part-containing substrates required to attain high-density mounting of electronic parts therein. Furthermore, since the resin has a low permittivity, it can be used for producing wiring circuit boards required to have suitability for high-speed signal processing.

While the present invention has been described in detail and with reference to specific embodiments thereof, it will be apparent to one skilled in the art that various changes and modifications can be made therein without departing from the spirit and scope thereof.

This application is based on Japanese patent application No. 2003-307301 filed August 29, 2003, the contents thereof being herein incorporated by reference.

## Claims

1. A thermosetting resin which has a tensile modulus after cure of from 0.001 to 1 GPa at 35°C and which has a resin flow rate before cure under heat and pressure at 150°C and $2.94 \times 10^{-1}$ MPa of from 5 to 50%.

2. The resin of claim 1, which comprises a polycarbodiimide comprising:

   $n_1$ pieces of structural units represented by general formula I:

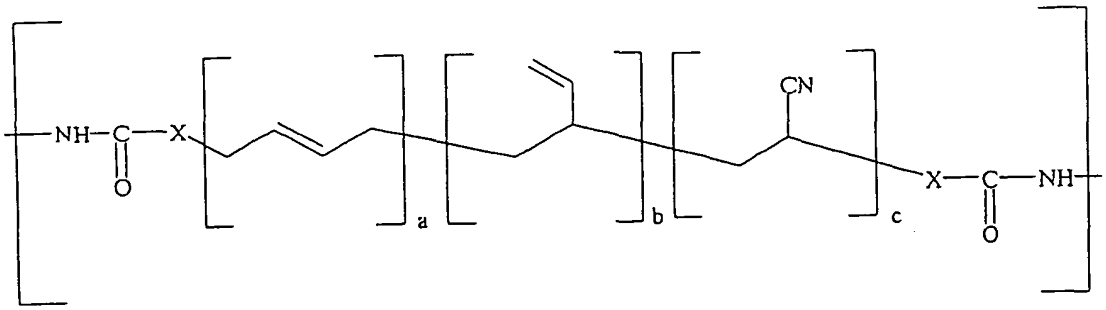

(I)

   wherein a, b, and c each are an integer of 0 to 200, provided that at least one of a, b and c is not 0; and X represents a single bond or an alkylene group having 1 to 5 carbon atoms;
   $n_2$ pieces of structural units represented by general formula II:

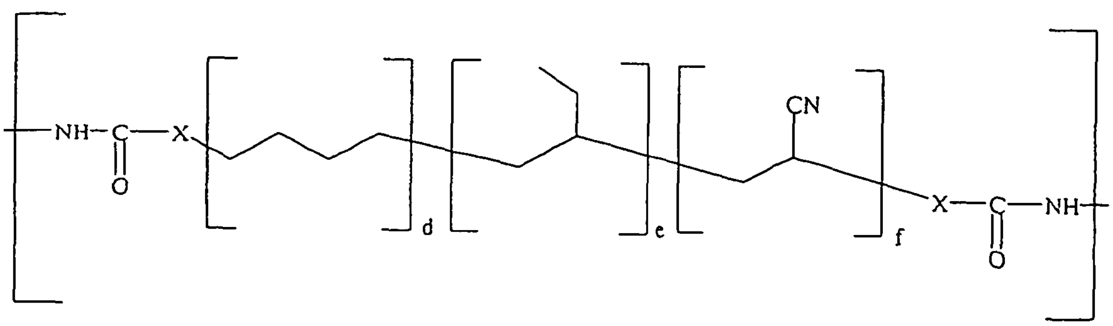

(II)

   wherein d, e, and f each are an integer of 0 to 200, provided that at least one of d, e and f is not 0; and X represents a single bond or an alkylene group having 1 to 5 carbon atoms; and
   $n_3$ pieces of structural units represented by general formula III:

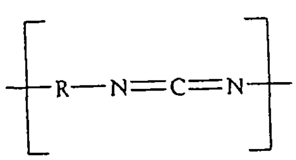

(III)

   wherein R represents a bivalent organic group having 4 to 40 carbon atoms, and
   having terminal structural units obtained by allowing each end of the molecules to react with a monoisocyanate,
   wherein $n_1+n_2$ is an integer of 2 or larger, $n_3$ is an integer of 1 or larger, $n_1+n_2+n_3$ is from 3 to 1,500, and $(n_1+n_2)/(n_1+n_2+n_3)$ is from 1/100 to 1/3.

**3.** An insulating material for electronic-part-containing substrates, which comprises the resin of claim 1 or 2.

**4.** An adhesive for wiring circuit boards, which comprises the resin of claim 2.